# EUROPÄISCHE PATENTANMELDUNG

(11) **EP 0 578 948 A1**
(43) Veröffentlichungstag der Anmeldung: **19.01.1994**
(21) Anmeldenummer: 93108150.9
(22) Anmeldetag: 19.05.1993
(51) Int. Cl.: G01R 21/08

(54) **Einrichtung zur Messung von Leistungs- und/oder Stromkomponenten einer Impedanz**

(30) Priorität: 14.07.1992 CH 2216/92
(71) Anmelder: Landis & Gyr Technology Innovation AG, CH-6301 Zug (CH)
(72) Erfinder: Döbele, Reinhard, CH-6312 Steinhausen (CH); Haller, Hans-Peter, CH-6330 Cham (CH); Huber, Anton, CH-6300 Zug (CH); Niepolomski, Andrzej, CH-6340 Baar (CH); Ricciardi, Bruno, CH-6030 Ebikon (CH); Thiébaud, Michel, CH-6332 Hagendorn (CH)
(74) Vertreter: Müller, Hans-Jürgen, Dipl.-Ing.

(57) **Zusammenfassung**

Eine Einrichtung zur Messung von Leistungs- und/oder Stromkomponenten einer Impedanz besteht aus Bausteinen (23; 24), welche je ein Hallelement und je einen Spannungs/Frequenz-Wandler aufweisen. Die Bausteine (23; 24) sind von einem elektrischen Leiter (6) umwunden und mit einem gemeinsamen Joch (21) und mit einer Abschirmung (22) versehen. Jeder Baustein (23; 24) ist je auf einer Leiterplatte (27; 28) angeordnet. Durch das vergossene Gehäuse (31) werden die Bausteine (23; 24), der Leiter 6, das Joch (21) und die Abschirmung (22) funktionsgerecht positioniert. Der Strom der Impedanz wird durch den Leiter (6) geschlauft. Eines der Hallelemente wird von einem Hallstrom gespeist, der in Phase zur Spannung an der Impedanz liegt; seine Ausgangsspannung ist proportional zur Wirkleistung der Impedanz. Der Hallstrom eines weiteren Hallelements eilt der Spannung an der Impedanz um 90° vor oder nach, so dass seine Ausgangsspannung proportional zur Blindleistung der Impedanz ist. Im Bedarfsfall weist eines der Hallelemente einen konstanten Hallstrom auf, sodass das Hallelement den Strom der Impedanz erfasst.

## Beschreibung

Die Erfindung bezieht sich auf eine Einrichtung zur Messung von Leistungs- und/oder Stromkomponenten einer Impedanz der im Oberbegriff des Anspruchs 1 genannten Art.

Solche Einrichtungen werden vorteilhaft in einem Eingangsteil in statischen Elektrizitätszählern zur Ermittlung der Wirkleistung oder der Wirk- und der Blindleistung oder auch der Wirkleistung, der Blindleistung und des Stromes verwendet.

Es ist eine Einrichtung dieser Art bekannt (US 4 742 296), welche im wesentlichen aus einem ein Hallelement aufweisenden Stromwandler und einem Spannungs/Frequenz-Wandler besteht und welche ein Signal mit einer zur Wirkleistung einer Impedanz proportionalen Frequenz erzeugt. Dabei wird die Spannung der Impedanz mittels eines Spannungs/Strom-Wandlers in einen als Hallstrom nutzbaren elektrischen Strom umgesetzt. Der Strom, der durch die Impedanz fliesst, verursacht in einem Leiter, welcher mindestens teilweise um das Hallelement geführt ist, ein Magnetfeld, so dass die Ausgangsspannung des Hallelements proportional zum Produkt aus dem Strom und der Spannung der Impedanz ist. Der dem Hallelement nachgeschaltete integrierende Spannungs/Frequenz-Wandler erzeugt ein Signal mit einer von der Wirkleistung abhängigen Frequenz.

Es ist auch ein Stromwandler mit einem Hallelement bekannt (US 4 749 939), der zur Ermittlung des momentanen Produkts aus dem Strom und der Spannung eines Verbrauchers verwendet werden kann.

Der Erfindung liegt die Aufgabe zugrunde, eine Einrichtung der im Oberbegriff des Anspruchs 1 genannten Art derart aufzubauen, dass sie zur Erfassung der Wirkleistung oder der Wirk- und der Blindleistung oder auch der Wirkleistung, der Blindleistung und des Stromes der Impedanz einer Last für verschiedene Leistungs- bzw. Strombereiche kostengünstig und in engen Toleranzen reproduzierbar in einem in grosser Stückzahl gefertigten statischen Elektrizitätszähler aufgebaut werden kann.

Die Erfindung besteht in den im Anspruch 1 angegebenen Merkmalen. Vorteilhafte Ausgestaltungen ergeben sich aus den abhängigen Ansprüchen.

Nachfolgend werden Ausführungsbeispiele der Erfindung anhand der Zeichnung naher erläutert.

Es zeigen:
- Fig. 1: ein Blockschaltbild einer Einrichtung zur Messung der Wirk- und der Blindleistung einer Impedanz,
- Fig. 2: eine Prinzipdarstellung der wesentlichen magnetischen Kreise eines Sensorblocks zur Ermittlung von zwei elektrischen Leistungskomponenten,
- Fig. 3: den Sensorblock zur Ermittlung von zwei elektrischen Leistungskomponenten einer Impedanz,
- Fig. 4: einen Aufriss des Sensorblocks,
- Fig. 5: einen Seitenriss des teilweise geschnittenen Sensorblocks,
- Fig. 6: einen zu einer Spule mit mehreren Windungen geformten elektrischen Leiter des Sensorblocks und
- Fig. 7: einen zu einer Spule mit einer einzigen Windung geformten elektrischen Leiter des Sensorblocks.

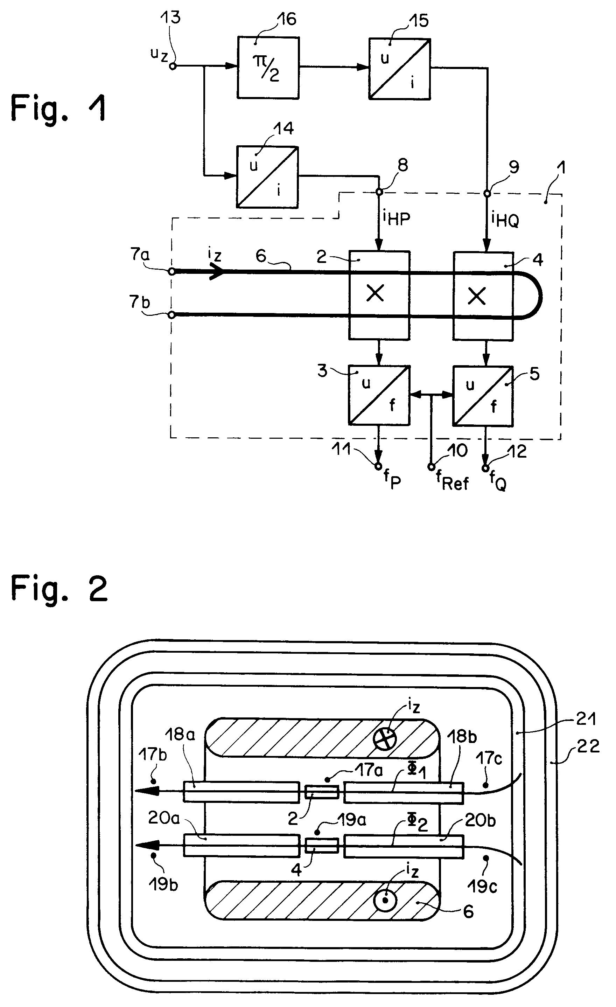

In der Fig. 1 bedeutet 1 eine gestrichelt dargestellte erste Variante eines Sensorblocks, der ein erstes Hallelement 2 mit einem ihm nachgeschalteten ersten Spannungs/Frequenz-Wandler 3, ein zweites Hallelement 4 mit einem ihm nachgeschalteten zweiten Spannungs/Frequenz-Wandler 5 sowie einen elektrischen Leiter 6 mit einem ersten Anschluss 7a und einem zweiten Anschluss 7b für einen Strom i_{z} zur Bildung eines Magnetfeldes aufweist, das durch die beiden Hallelemente 2, 4 erfassbar ist. Der Sensorblock 1 verfügt über einen ersten, mit dem ersten Hallelement 2 verbundenen Eingang 8 für einen Hallstrom i_{HP}, einen zweiten, mit dem zweiten Hallelement 4 verbundenen Eingang 9 für einen Hallstrom i_{HQ}, einen dritten, mit dem ersten Spannungs/Frequenz-Wandler 3 und dem zweiten Spannungs/Frequenz-Wandler 5 verbundenen dritten Eingang 10 für eine Referenzfrequenz f_{Ref}, einen ersten, mit dem Ausgang des ersten Spannungs/Frequenz-Wandlers 3 verbundenen Signalausgang 11 für ein Signal f_{P} und einen zweiten, mit dem Ausgang des zweiten Spannungs/Frequenz-Wandlers 5 verbundenen Signalausgang 12 für ein weiteres Signal f_{Q}. Ein weiterer Anschluss 13 für eine Spannung u_{z} führt auf den Eingang eines ausgangsseitig mit dem ersten Eingang 8 verbundenen ersten Spannungs/Strom-Wandlers 14 sowie auf den Eingang eines ausgangsseitig über einen zweiten Spannungs/Strom-Wandler 15 mit dem zweiten Eingang 9 verbundenen Phasenschiebers 16.

Eine zweite Variante des Sensorblocks 1 entspricht der ersten Variante, welche zusätzlich den ersten Spannungs/Strom-Wandler 14 aufweist, eine dritte Variante ist die um den zweiten Spannungs/Strom-Wandler 15 erweiterte zweite Variante, und eine vierte Variante stellt die um den Phasenschieber 16 erweiterte dritte Variante des Sensorblocks 1 dar.

Die Fig. 2 zeigt das erste Hallelement 2, das in einem mittleren Luftspalt 17a von mindestens drei zu einem ersten zweiteiligen Innenschenkel 18a und 18b gehörenden Luftspalten 17a, 17b und 17c angeordnet ist. Das zweite Hallelement 4 liegt in einem mittleren Luftspalt 19a von mindestens drei zu einem zum ersten Innenschenkel 18a und 18b parallel liegenden zweiten zweiteiligen Innenschenkel 20a und 20b gehörenden Luftspalten 19a, 19b und 19c. Die beiden Innenschenkel 18a, 18b und 20a, 20b sind in einem rohrförmigen Joch 21, welches im wesentlichen eine rechteckige Öffnung aufweist, mit Vorteil sowohl parallel nebeneinander um die Rohrachse des Jochs 21 wie auch rechtwinklig zur Rohrachse angeordnet. Der in der Fig. 2 geschnitten dargestellte Leiter 6 umfasst die Innenschenkel 18a, 18b und 20a, 20b mindestens teilweise, womit diese durch den Leiter 6 magnetisch erregbar sind. Das Joch 21 ist in einer magnetischen Abschirmung 22 angeordnet, wobei die Abschirmung 22 die äussere Mantelfläche des Jochs 21 mit Vorteil überlappend abdeckt.

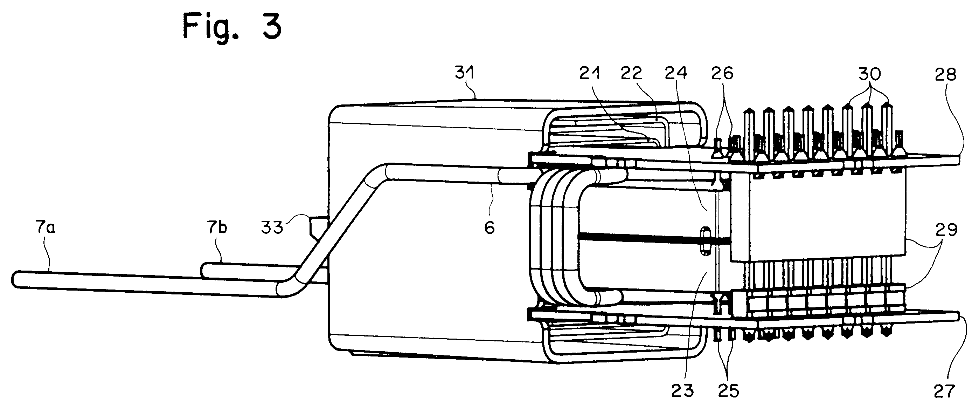

Die Fig. 3, die Fig. 4 und die Fig. 5 zeigen den gleichen Sensorblock 1 in einem Aufbau, nach welchem jede seiner vier Varianten je als eine einzige Einheit zur Ermittlung von zwei elektrischen Leistungskomponenten einer Impedanz aufgebaut werden kann.

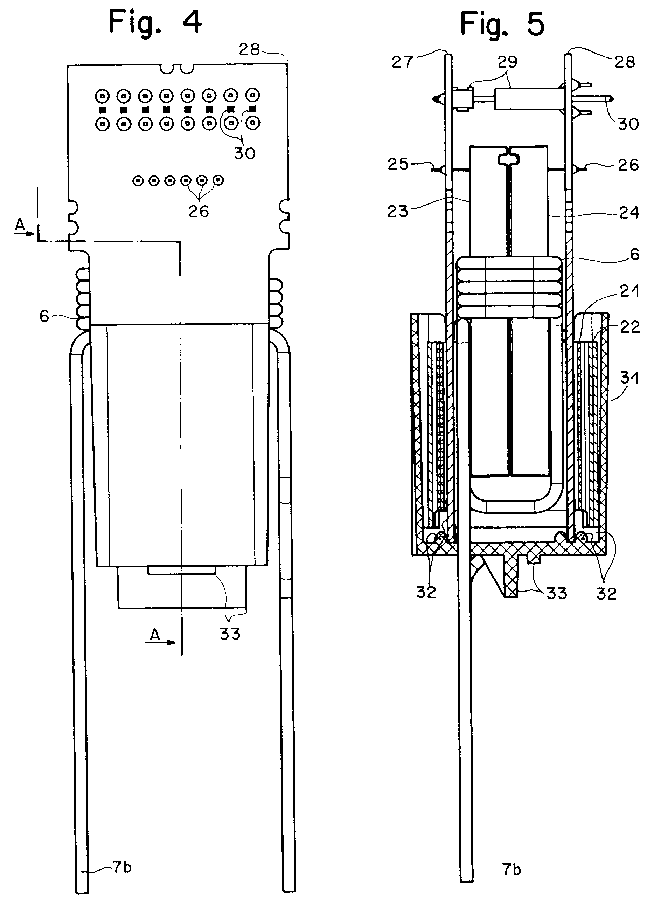

In der Fig. 4 ist eine Schnittlinie A-A eingezeichnet, nach deren Verlauf der Sensorblock 1 in der Fig. 5 teilweise geschnitten dargestellt ist.

Ein erster elektronischer Baustein 23 mit einem bekannten Aufbau (US 4 742 296, US 4 749 939, US 4 782 375, US 4 987 467, US 4 728 886) enthält das erste Hallelement 2, den ersten Innenschenkel 18a, 18b und den ersten Spannungs/Frequenz-Wandler 3. Des weiteren sind in einem zweiten elektronischen Baustein 24, der gleich wie der erste Baustein 23 aufgebaut ist, das zweite Hallelement 4, der zweite Innenschenkel 20a, 20b und der zweite Spannungs/Frequenz-Wandler 5 angeordnet. Beide Bausteine 23, 24 sind mittels elektrischen Anschlussstiften 25 bzw. 26 an je einer Leiterplatte 27 bzw. 28 angebracht, wobei die beiden Leiterplatten 27, 28 über ein elektrisches Verbindungsglied 29 miteinander verbunden sind und über Anschlusssteckerstifte 30 elektrisch angeschlossen werden. Bei Bedarf ist auf der ersten Leiterplatte 27 der erste Spannungs/Strom-Wandler 14 angeordnet und/oder die zweite Leiterplatte weist den zweiten Spannungs/Strom-Wandler 15 allein oder zusammen mit dem Phasenschieber 16 auf.

Die Signalausgänge 11 und 12 (Fig. 1), der Eingang 10 sowie die Eingänge 8 und 9 bzw. der Anschluss 13 sind über die Anschlusssteckerstifte 30 (Fig. 3) kontaktierbar.

In einer kostengünstig und einfach montierbaren Ausführung des Sensorblocks 1 sind die Anschlusssteckerstifte 30 Teile des Verbindungsglieds 29, das mit Vorteil eine steckbare Verbindung aus zwei Steckereinheiten ist, wobei jede der Steckereinheiten fest mit einer der beiden Leiterplatten 27 oder 28 verbunden ist und eine der Steckereinheiten die Anschlusssteckerstifte 30 aufweist.

Der elektrische Leiter 6 ist derart um die beiden Bausteine 23 und 24 geführt, dass die beiden Innenschenkel 18a, 18b und 20a, 20b vom Leiter 6 umwunden sind.

Das rohrförmige Joch 21 umschliesst die beiden Bausteine 23 und 24 sowie auch teilweise den Leiter 6 und schliesst dabei die beiden Innenschenkel 18a, 18b und 20a, 20b magnetisch kurz.

Der Sensorblock 1 weist ein Gehäuse 31 auf, in welchem die Bausteine 23 und 24, die Leiterplatten 27 und 28, der Leiter 6, das Joch 21 und die Abschirmung 22 angeordnet und festgehalten sind. Das Gehäuse 31 ist vorteilhaft mit einer Giessmasse vergossen und weist in seiner Gestalt Positionierungsmittel 32 (Fig. 5) für die genaue Positionierung der beiden Leiterplatten 27 und 28, des Jochs 21 und der Abschirmung 22 auf. Zusammen mit der Leiterplatte 27 bzw. 28 ist auch der Baustein 23 bzw. 24 genau und funktionsgerecht positioniert.

Das Joch 21 und die Abschirmung 22 sind durch die Positionierungsmittel 32 und die Giessmasse voneinander elektrisch isoliert angeordnet.

Im weiteren sind am Gehäuse 31 mit Vorteil auch Befestigungsmittel 33 in der Form von Einschnapprippen ausgebildet, mit deren Hilfe der Sensorblock 1 beispielsweise in einem Elektrizitätszähler befestigt wird.

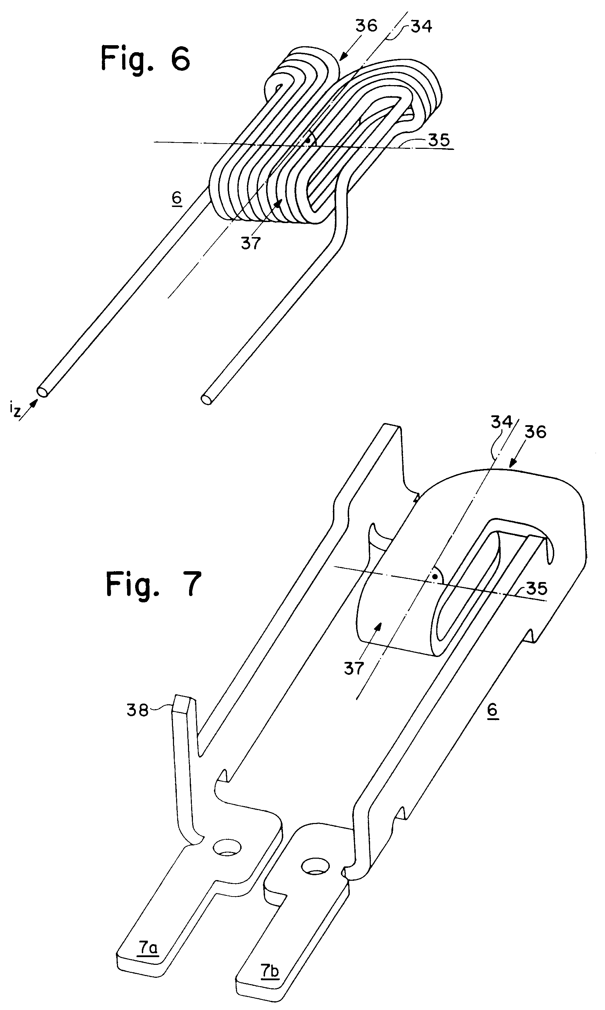

Die Fig. 6 zeigt eine vorteilhafte Ausführung des Leiters 6 in der Gestalt einer im wesentlichen einen rechtkantigen Spulen-Innenraum umfassenden Spule, welche mehrere Windungen aufweist. Die Windungen sind an einer der Spulenseiten symmetrisch zu einer Einschiebachse 34, die rechtwinklig zu einer magnetischen Polachse 35 der vom Strom i_{z} durchflossenen Spule liegt und im wesentlichen durch die Spulenmitte verläuft, derart von der Einschiebachse 34 weg aufgebogen, dass in der Spule zwischen den Windungen eine Öffnung 36 zum Spulen-Innenraum ausgebildet ist. Die Spule ist einlagig gewickelt, wobei die einzelnen Windungen mit Ausnahme von zwei Windungen, welche die Öffnung 36 begrenzen, aneinander anliegen.

Die beiden Enden des Leiters 6 mit den Anschlüssen 7a und 7b sind parallel zur Einschiebachse 34 weggeführt.

Der Baustein 23 bzw. 24 oder beide Bausteine 23, 24 zusammen werden bei der Montage parallel zur Einschiebachse 34 durch die Öffnung 36 in die Spule eingefügt, während von einer der Öffnung 36 gegenüber liegenden Spulenseite 37 her das Joch 21, die Abschirmung 22 und das Gehäuse 31 koaxial zur Einschiebachse 34 angebracht werden können. Die Gestalt des Leiters 6 ermöglicht einen äusserst dichten und dennoch einfach montierbaren Aufbau des Sensorblocks 1.

Die Fig. 7 zeigt die vorteilhafte Ausführung des Leiters 6, wenn die Spule nur eine einzige Windung aufweist. Der in einem mehrschrittigen Stanz-Biege-Verfahren herstellbare Leiter 6 ist als Flachleiter ausgeführt. Die beiden Anschlüsse 7a und 7b sind für Klemmverbindungen ausgearbeitet. Im weiteren weist der Leiter 6 einen Anschlussstift 38 auf, über den das elektrische Potential des Leiters 6 abgegriffen werden kann.

Der Sensorblock 1 ist eine Einrichtung zur Messung von Leistungs- und/oder Stromkomponenten einer Impedanz; seine Funktionsweise ist im folgenden beschrieben.

Die Spannung u_{z} der Impedanz liegt am Anschluss 13 (Fig. 1), während der durch die Impedanz fliessende Strom i_{z} mittels der beiden Anschlüsse 7a und 7b durch den Leiter 6 geführt ist.

Der Strom i_{z} generiert einerseits im ersten Innenschenkel 18a, 18b (Fig. 2) und im ersten Hallelement 2 einen magnetischen Fluss Φ₁ und anderseits im zweiten Innenschenkel 20a, 20b und im zweiten Hallelement 4 einen weiteren magnetischen Fluss Φ₂, wobei die beiden Flüsse Φ₁ und Φ₂ über das Joch 21 geschlossen sind. Die magnetische Induktion im ersten Hallelement 2 wie auch diejenige im zweiten Hallelement 4 ist proportional zum Strom i_{z} und im wesentlichen durch die Luftspalten 17a, 17b und 17c oder 19a, 19b und 19c bestimmt.

Die Wirkung des Stromes i_{z} auf die magnetische Induktion in den Hallelementen 2 und 4 wird vergrössert, indem der Leiter 6 in mehreren Windungen gemeinsam um die beiden Innenschenkel 18a, 18b und 20a, 20b geführt wird. Einem dekadischen System entsprechend weist der Leiter 6 mit Vorteil entweder eine oder zehn Windungen auf. Bei Bedarf kann der Leiter 6 aber auch als Spule mit einer Windungszahl grösser eins und ungleich zehn ausgeführt sein.

Der erste Spannungs/Strom-Wandler 14 (Fig. 1), das erste Hallelement 2 und der erste Spannungs/Frequenz-Wandler 3 bilden in bekannter Weise zusammen einen ersten Messpfad, dessen Signalausgang 11 ein zur Wirkleistung der Impedanz proportionales Signal f_{P} aufweist. Der Spannungs/Strom-Wandler 14 ist mit Vorteil ein ohmscher Widerstand mit einem reellen Wert, welcher bei Bedarf abgleichbar ist.

Ein zweiter Messpfad besteht aus dem Phasenschieber 16, dem zweiten Spannungs/Strom-Wandler 15, dem zweiten Hallelement 4 und dem zweiten Spannungs/Frequnz-Wandler 5. Der Phasenschieber 16 erzeugt ausgangsseitig eine zur Spannung u_{z} um plus oder minus 90° (π/2) verschobene Spannung, aus welcher der Spannungs/Strom-Wandler 15 den Hallstrom i_{HQ} generiert. Der Phasenschieber 16 ist mit Vorteil ein Tiefpass, der eine Grenzfrequenz kleiner 1 Hz aufweist, deshalb erfordert der Spannungs/Strom-Wandler 15 zur Erreichung einer relativ hohen Eingangsimpedanz vorzugsweise mindestens einen Transistor.

Die Ausgangsspannung des Hallelementes 4 ist proportional zum Produkt aus dem Strom i_{z} und dem Hallstrom i_{HQ} und damit proportional zur Blindleistung der Impedanz. Der Spannungs/Frequenz-Wandler 5 erzeugt mit Hilfe der Referenzfrequenz f_{Ref} in bekannter Weise ein Signal f_{Q}, dessen Frequenz proportional zur Ausgangsspannung des Hallelements 4 und damit auch proportional zur Blindleistung der Impedanz ist.

Die Einrichtung mit den beiden Messpfaden ermöglicht die Messung der Wirk- und der Blindleistung einer Impedanz. Sowohl durch die vorteilhafte Anordnung der beiden Hallelemente 2, 4 und des Leiters 6, wie auch durch dessen Formgebung, ist die Einrichtung im Sensorblock 1 kompakt aufgebaut. Beide Messpfade haben den Leiter 6, das Joch 21, die Abschirmung 22 und das Gehäuse 31 gemeinsam. Im weiteren sind die Anschlusssteckerstifte 30 über einen einzigen, in der Zeichnung nicht dargestellten Stecker anschliessbar.

Durch die kompakte und mechanisch wie auch messtechnisch robuste und stabile Ausführung ist der Sensorblock 1 gut lagerfähig. Die Ausführung mit den Befestigungsmitteln 33 und den Anschlusssteckerstiften 30 ermöglicht einen raschen und sicheren Einbau des vorgefertigten Sensorblocks 1 in einphasige oder auch in mehrphasige Leistungs- oder Energiemessgeräte. Ebenso kann der Sensorblock 1, beispielsweise im Störungsfall, mit einfachen Werkzeugen und geringem Zeitbedarf als Einheit ausgetauscht werden.

Bei Bedarf enthält der Sensorblock 1 nur einen der beiden Messpfade. In diesem Fall wird einer der beiden Bausteine 23 bzw. 24 entweder durch eine Attrappe ersetzt oder zusammen mit der dazugehörenden Leiterplatte 27 bzw. 28 nicht eingebaut.

Der Sensorblock 1 enthält im Bedarfsfall mehr als zwei Messpfade zur vorteilhaften Messung mehrerer verschiedener Leistungskomponenten oder auch zur Messung von Leistungskomponenten und Strömen. In diesem Fall weist der Kern mehrere parallele Innenschenkel mit je einem Luftspalt auf, wobei alle Innenschenkel vom elektrischen Leiter 6 gemeinsam mindestens teilweise umwunden sind und in jedem Innenschenkel im Luftspalt ein Hallelement angeordnet ist. Eines der Hallelemente misst entweder eine Leistungskomponente oder, falls der Hallstrom des Hallelementes einen bestimmten konstanten Wert aufweist, einen elektrischen Strom. Ein Sensorblock 1 mit drei Innenschenkeln kann beispielsweise die Wirkleistung, die Blindleistung und den Strom i_{z} der Impedanz messen.

Die Grösse der Öffnung (36) ist auf die Anzahl und die Abmessung der die Hallelemente enthaltenden Bausteine abgestimmt.

## Patentansprüche

1. Einrichtung zur Messung von Leistungs- und/oder Stromkomponenten einer Impedanz, mit einem zu einer Spule mit mindestens einer Windung ausgebildeten elektrischen Leiter (6) und einem aus einem Innenschenkel (18a, 18b) mit einem Luftspalt (17a) und einem Joch (21) bestehenden ferromagnetischen Kern, sowie mit einer den Kern umfassenden magnetischen Abschirmung (22), wobei der Innenschenkel (18a, 18b) vom elektrischen Leiter (6) mindestens teilweise umwunden ist und im Luftspalt (17a) ein Hallelement (2) aufweist, mit dem eine Leistungskomponente erfassbar ist, dadurch gekennzeichnet, dass die Spule im wesentlichen einen rechtkantigen Spulen-Innenraum umfasst und dass die Windung oder Windungen der Spule an einer Spulenseite symmetrisch zu einer rechtwinklig zur Polachse (35) der Spule liegenden und durch die Spulenmitte verlaufenden Einschiebachse (34) derart eine Öffnung (36) bildend von der Einschiebachse (34) weg aufgebogen ist oder sind, dass parallel zur Einschiebachse (34) mindestens ein Baustein (23), welcher mindestens das Hallelement (2) enthält, durch die Öffnung (36) in den Spulen-Innenraum einschiebbar ist.

2. Einrichtung nach Anspruch 1, dadurch gekennzeichnet, dass die Spule eine einzige Windung aufweist.

3. Einrichtung nach Anspruch 1, dadurch gekennzeichnet, dass die Spule mehr als eine Windung aufweist.

4. Einrichtung nach einem der Ansprüche 1 bis 3, dadurch gekennzeichnet, dass der Kern einen zum Innenschenkel (18a, 18b) parallelen zweiten Innenschenkel (20a, 20b) mit einem Luftspalt (19a) aufweist, dass die beiden Innenschenkel (18a, 18b; 20a, 20b) vom elektrischen Leiter (6) gemeinsam mindestens teilweise umwunden sind, dass im Luftspalt (19a) des zweiten Innenschenkels (20a, 20b) ein zweites Hallelement (4) angeordnet ist, mit welchem eine zweite Leistungskomponente erfassbar ist und welches in einem Baustein (24) im Spulen-Innenraum angeordnet ist.

5. Einrichtung nach einem der Ansprüche 1 bis 3, dadurch gekennzeichnet, dass der Kern mehrere parallele Innenschenkel mit Luftspalten aufweist, dass alle Innenschenkel vom elektrischen Leiter (6) gemeinsam mindestens teilweise umwunden sind, dass in jedem Innenschenkel je in einem Luftspalt ein Hallelement angeordnet ist, mit welchem je eine Leistungskomponente oder ein elektrischer Strom erfassbar ist und welches in einem Baustein im Spulen-Innenraum angeordnet ist.

6. Einrichtung nach Anspruch 4, dadurch gekennzeichnet, dass das Hallelement (2), der Innenschenkel (18a, 18b) und ein Spannungs/Frequenz-Wandler (3) in einem Baustein (23) und das zweite Hallelement (4), der zweite Innenschenkel (20a, 20b) und ein weiterer Spannungs/Frequenz-Wandler (5) in einem zweiten Baustein (24) angeordnet sind, dass die beiden Bausteine (23; 24) je auf einer Leiterplatte (27; 28) angeordnet sind und dass die beiden Leiterplatten (27; 28) gemeinsame Anschlusssteckerstifte (30) für die elektrischen Anschlüsse aufweisen.

7. Einrichtung nach einem der Ansprüche 1 bis 6, dadurch gekennzeichnet, dass das Joch (21) ein im wesentlichen vierkantiges gerades Rohr ist, welches die Spule mindestens teilweise einhüllt.

8. Einrichtung nach einem der Ansprüche 1 bis 7, dadurch gekennzeichnet, dass die äussere Mantelfläche des Jochs (21) elektrisch isoliert von einer magnetischen Abschirmung (22) umgeben ist.

9. Einrichtung nach Anspruch 8, dadurch gekennzeichnet, dass die Bausteine (23; 24), deren Leiterplatten (27; 28) mit den Anschlusssteckerstiften (30), der Leiter (6), das Joch (21) und die Abschirmung (22) in einem Gehäuse (31) mechanisch und messtechnisch eine stabile und austauschbare Baueinheit bildend angeordnet sind.

10. Einrichtung nach Anspruch 9, dadurch gekennzeichnet, dass das Gehäuse (31) mit einer Giessmasse vergossen ist.
